# EUROPEAN PATENT APPLICATION

(11) **EP 4 016 644 A1**
(43) Date of publication of application: **22.06.2022**
(21) Application number: 20216022.2
(22) Date of filing: 21.12.2020
(51) Int. Cl.: H01L 29/78, H01L 29/16, H01L 29/423, H01L 29/66

(54) **POWER SEMICONDUCTOR DEVICE AND METHOD FOR MANUFACTURING A POWER SEMICONDUCTOR DEVICE**

(71) Applicant: Hitachi Energy Switzerland AG, 5400 Baden (CH)
(72) Inventor: Wirths, Stephan, 8800 Thalwil (CH); Knoll, Lars, 5607 Hägglingen (CH); Mihaila, Andrei, 5415 Rieden (CH)
(74) Representative: Epping - Hermann - Fischer

(57) **Abstract**

A power semiconductor device (1) is described comprising:
- a first main electrode (3),
- a second main electrode (4),
- a gate electrode layer (5) between the first main electrode (3) and the second main electrode (4),
- a first insulating layer (6) comprising at least one of a plurality of first insulating layer portions (6A) traversing the gate electrode layer (5) and of at least one second insulating layer portion (6B) arranged on a side of the gate electrode layer (5) facing the second main electrode (4),
- a semiconductor layer stack (2) between and in electrical contact with the first main electrode (3) and the second main electrode (4), the semiconductor layer stack (2) comprising:
- silicon carbide,
- differently doped semiconductor layers (13, 14A, 14B, 15A, 15B), wherein at least two semiconductor layers (13, 14A, 14B, 15A, 15B) differ in at least one of their conductivity type and their doping concentration,
- a plurality of pillar-shaped or fin-shaped regions (20), which traverse the gate electrode layer (5) and which each comprise a contact layer (21) arranged at the first main electrode (3) with a first doping concentration and with a first conductivity type,
wherein
each contact layer (21) extends to a side (5A) of the gate electrode layer (5) facing the first main electrode (3).

Moreover, a method for producing a power semiconductor device (1) is described.

## Description

A power semiconductor device is provided. A manufacturing method for such a power semiconductor device is also provided. The power semiconductor device may be a silicon carbide device.

Silicon carbide (SiC) based devices compared to common silicon (Si) based devices have a much higher breakdown field strength and thermal conductivity and enable reaching otherwise unattainable efficiency levels. 4H-SiC is a suitable polytype for power electronics, such as metal-oxide-semiconductor field effect transistors (MOSFETs) or accumulation- mode MOSFETs (ACCUFETs), due to the advances in the field of 4H-SiC growth technology as well as its attractive electronic properties such as the larger band gap compared to other available wafer-scale polytypes, e.g. 6H SiC or 3C-SiC. Although, 4H-SiC power MOSFETs and power ACCUFETS are already commercially available, there is large room for improvements, for example regarding inversion channel mobility of power MOSFETs in order to further decrease on-resistance Rₒₙ.

Most of the commercially available power field effect transistors based on silicon carbide (SiC) are implemented with a planar design, where a channel is formed on a surface of a wafer, such as in a vertical double diffused metal oxide semiconductor field effect transistor (VDMOS). However, current densities in these devices are difficult to increase since the p-type implantations in an n-channel VDMOS form the gates of a parasitic junction field effect transistor (JFET) that tend to reduce the width of the current flow.
Trench metal oxide semiconductor field effect transistors (MOSFETs) enable the achievement of low on-resistance Rₒₙ because of lack of the parasitic JFET. Additionally, for SiC, the trench MOSFET architecture permits optimization of carrier mobility by designing the channel with respect to different crystallographic planes. A SiC trench MOSFET is known for example from US 2018/0350977 A1. Known methods for manufacturing SiC based trench MOSFETS rely on etching a deep trench into SiC for forming the trench-type gate electrodes. Etching SiC is difficult and costly compared to etching other semiconductor materials such as silicon (Si).

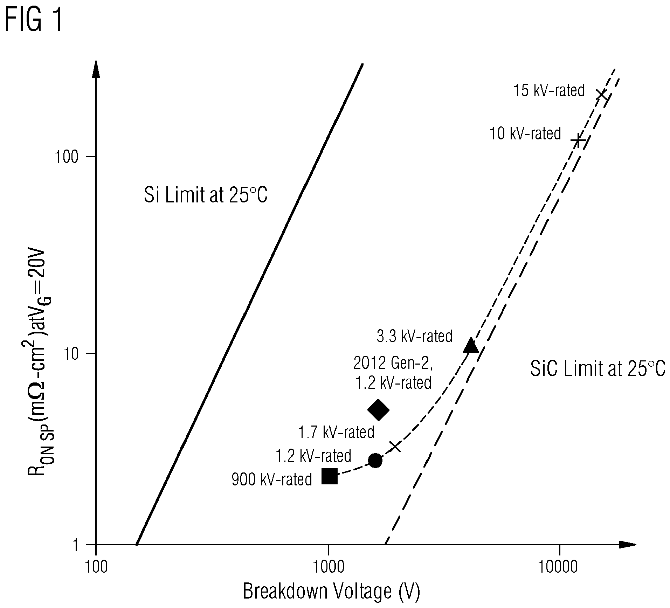

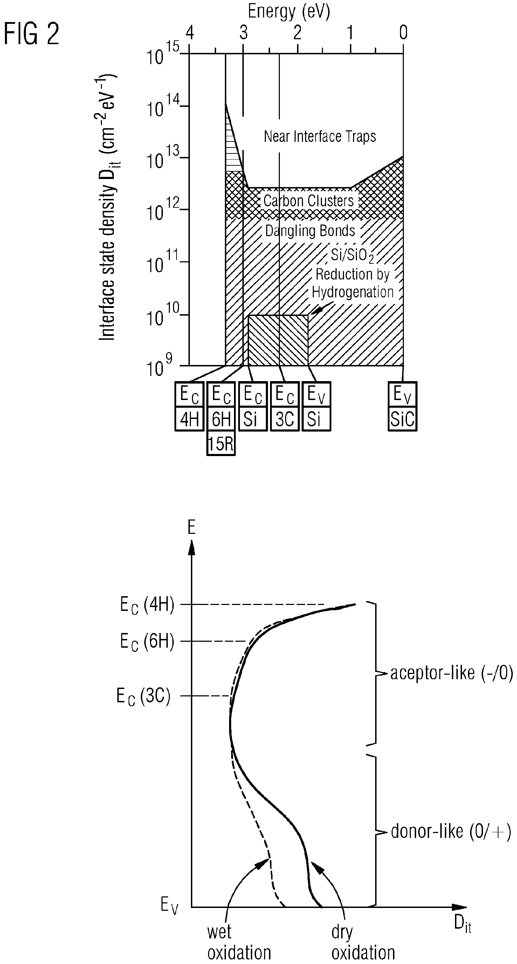

Whereas for higher voltage classes >3 kV the drift layer resistance R_{drift} dominates on-resistance Rₒₙ, reduction of the latter is, however, essential in commercially more relevant lower voltage classes (e.g. voltage classes ≤1.7 kV) - used for electric and hybrid electric vehicles (EVs/HEVs) - in order to significantly reduce the on-state power and switching losses. Here, Rₒₙ is still considerably higher than ideal as shown in FIG. 1. In this respect, low inversion channel mobility represents one of the main challenges that might have significant impact on device costs and hence widespread adoption of SiC power MOSFETs. Boosting the inversion channel mobility using improved gate stacks as well as SiC/oxide interfaces showed limited success, but is known as one of the most important milestones in the development and commercialization of SiC power MOSFETs. In the late 90s, the introduction of nitric oxide (NO) post-oxidation for 6H-SiC and its application to 4H-SiC MOSFETs in 2001 enabled an enormous increase in inversion layer electron mobility, because the introduction of nitrogen (N) near the interface via NO annealing reduces the interface defect density Dᵢₜ (see Figure 2). However, there is a strong demand for higher mobility devices beyond state-of-the-art NO annealed SiC MOSFETs particularly in order to expand SiC MOSFETs into the low voltage class markets.

Furthermore, problems that could be avoided by a higher channel mobility in addition to reaching ideal/lower Rₒₙ are as follows:
a) the gate can be driven at lower voltages resulting in smaller electric fields in the gate oxide layer, which improves threshold stability and oxide long-term reliability, and
b) aggressive scaling of the transistor channel length is not required in order to reduce the channel resistance, thus, short channel effects can be avoided.

Alternative strategies to reduce interface defects beyond the NO treatment are the introduction of interfacial layers with trace impurities, surface counter-doping, higher temperature oxidations and alternative non-polar crystal faces (instead of conventional polar Si-face) due to their inherently high mobility.

Besides the inversion channel mobility and the drift layer resistance R_{drift}, there are other parameters which effect the on-resistance Rₒₙ and thus are worth improving, like, for example, the source resistance R_{S}, which represents all resistances between a source terminal of the device to a channel of the device and includes, for example, the resistance of wire bonds, of a source metallization, and of a source layer.

A problem to be solved is to provide a power semiconductor device having a high efficiency.

Exemplary embodiments of the disclosure address the above shortcomings, inter alia, by a power semiconductor device and by a manufacturing method as defined in the independent patent claims. Exemplary further developments constitute the subject matter of the dependent patent claims.

According to at least one embodiment, the power semiconductor device comprises a first main electrode, a second main electrode and a gate electrode layer between the first main electrode and the second main electrode. The power semiconductor device further includes a first insulating layer comprising at least one of a plurality of first insulating layer portions traversing the gate electrode layer and of at least one second insulating layer portion arranged on a side of the gate electrode layer facing the second main electrode. The second insulating layer portion may be a continuous layer or a discontinuous layer comprising a plurality of second insulating layer portions. For example, "to traverse" means "to run through".

And the power semiconductor device comprises a semiconductor layer stack between and in electrical contact with the first main electrode and the second main electrode. Here, the semiconductor layer stack being arranged "between" the first main electrode and the second main electrode means that the first main electrode and the second main electrode define a space where the semiconductor layer stack is arranged. The semiconductor layer stack contains silicon carbide.

Moreover, the semiconductor layer stack comprises differently doped semiconductor layers, wherein at least two semiconductor layers differ in at least one of their conductivity type and their doping concentration. The semiconductor layer stack further comprises a plurality of pillar-shaped or fin-shaped regions, which traverse the gate electrode layer and which each comprise a contact layer arranged at the first main electrode with a first doping concentration and with a first conductivity type. Each contact layer extends to a side of the gate electrode layer facing the first main electrode. The gate electrode layer may be laterally overgrown by the contact layers such that its side facing the first main electrode is covered at least partly by the contact layers.

During operation of the power semiconductor device, in an on-state of the power semiconductor device, that is, for example, when a positive gate bias is applied, a current flows through the semiconductor layer stack between the first main electrode and the second main electrode. In an off-state of the power semiconductor device, that is, for example, when the gate bias is zero, a current flow between the first main electrode and the second main electrode is blocked. For example, the first main electrode is the source electrode and the second main electrode is the drain electrode of the power semiconductor device. Moreover, each pillar-shaped or fin-shaped region may comprise a source layer at the first main electrode, wherein the source layer comprises the contact layer or consists of the contact layer.

The contact layers may comprise or consist of a wide bandgap material such as at least one of silicon carbide, for example 3C-SiC, or GaN. Moreover, the contact layers may be highly doped layers. For example, the first doping concentration may range between 10¹⁹ and 10²⁰ cm⁻³.

The gate electrode layer may be a highly doped Si layer or a metal layer, for example a layer of Al.

In the context of the present application, "pillar-shaped regions" may be regions having a main extension direction running obliquely or perpendicularly to a device plane, which is a main extension plane of the device. Moreover "fin-shaped regions" may be regions having a main extension direction along the device plane. For example, the pillar-shaped regions may have in each case the shape of a truncated cone, of a truncated pyramid, of a prism or of a cylinder. The fin-shaped regions may have in each case the shape of a prism.

The pillar-shaped or fin-shaped regions may be referred to as nanowires or microwires. For example, document US 2016/0351391 A1 refers to semiconductor nanowire production.

According to at least one embodiment, each pillar-shaped or fin-shaped region has a first lateral extension along the device plane, which is below 2 µm, or below 1 µm. The first lateral extension is the shorter one of two lateral extensions running obliquely to each other.

The contact layers extending to the side of the gate electrode layer facing the first main electrode have the advantage that each pillar-shaped or fin-shaped region has an increased contact area at the side facing the first main electrode. Exemplarily, the contact area of each pillar-shaped or fin-shaped region can be increased by a factor of at least 2.

The increased contact areas have the positive effect of a reduced contact resistance at the transition between the first main electrode and the contact layers and thus may reduce the source resistance R_{S}.

According to at least one embodiment of the power semiconductor device, the contact layers of adjacent pillar-shaped or fin-shaped regions merge on the side of the gate electrode layer facing the first main electrode. In other words, the contact layers of adjacent pillar-shaped or fin-shaped regions are arranged continuously on the side of the gate electrode layer facing the first main electrode.

According to at least one embodiment of the power semiconductor device, the semiconductor layer stack comprises a plurality of channel layers each assigned to one pillar-shaped or fin-shaped region and arranged at sides of the contact layers facing away from the first main electrode. The channel layers have a second doping concentration and a second conductivity type, wherein at least one of the second doping concentration differs from the first doping concentration and the second conductivity type differs from the first conductivity type. The channel layers may comprise or consist of silicon carbide, for example 3C-SiC.

For example, the first conductivity type is of n-type, whereas the second conductivity type is of p-type. However, it is also possible for the first conductivity type to be p-type and for the second conductivity type to be n-type. Moreover, the first conductivity type and the second conductivity type may be the same, for example n-type or p-type. If the first conductivity type and the second conductivity type are of the same type, for example of the n-type, the first doping concentration may exceed the second doping concentration, exemplarily by at least a factor of 10. For example, the first doping concentration may range between 10¹⁹ and 10²⁰ cm⁻³, whereas the second doping concentration may range between 10¹⁶ and 10¹⁷ cm⁻³.

According to at least one embodiment of the power semiconductor device, the first insulating layer is arranged between the gate electrode layer and the channel layers such that the gate electrode layer is electrically separated from each one of the channel layers. The first insulating layer may contain or consist of at least one of silicon dioxide or silicon nitride. A layer thickness of the first insulating layer is exemplarily in a range between 5 and 500 nm, wherein the layer thickness designates a maximum extent in a direction parallel to a surface normal of the first insulating layer.

The shape of the first insulating layer portions may correspond to the shape of the lateral surfaces of the pillar-shaped or fin-shaped regions, which, as mentioned above, may each have the shape of a truncated cone, of a truncated pyramid, of a prism or of a cylinder. The first insulating layer portions may respectively extend directly on the lateral surface(s) of the plurality of pillar-shaped or fin-shaped regions so that the plurality of first insulating layer portions cover at least a portion of the contact layer of each pillar-shaped or fin-shaped region.

According to at least one embodiment of the power semiconductor device, the channel layers are at least partly arranged in a common plane with the gate electrode layer, and the first insulating layer comprises first insulating layer portions extending on lateral surfaces of the pillar-shaped or fin-shaped regions. This embodiment allows for a MOSFET or ACCUFET design of the power semiconductor device.

The principal difference between an ACCUFET using an accumulation-channel and a metal-oxide semiconductor FET using an inversion channel is the presence of a channel layer, that is, an accumulation layer, below and/or next to the first insulating layer. The thickness, length, and doping concentration of this accumulation layer can be carefully chosen so that it is completely depleted in operation.

According to at least one embodiment, for example if the power semiconductor device has an ACCUFET design, the first conductivity type and the second conductivity type are of the same type, for example of the n-type, and the first doping concentration exceeds the second doping concentration, exemplarily by at least a factor of 10. For example, the first doping concentration may range between 10¹⁹ and 10²⁰ cm⁻³, whereas the second doping concentration may range between 10¹⁶ and 10¹⁷ cm⁻³.

According to at least one embodiment, for example if the power semiconductor device has a MOSFET design, the first conductivity type and the second conductivity type are different, and each pillar-shaped or fin-shaped region may comprise a drain layer of the first conductivity type arranged on a side of the channel layer facing away from the contact layer. Exemplarily, the drain layer comprises 4H-SiC or 6H-SiC.

The first insulating layer portions may respectively surround laterally partly or completely a corresponding one of the pillar-shaped or fin-shaped regions to form a plurality of vertical gate-all-around field effect transistor cells. Gate-all-around field effect transistor cells allow a most efficient gate control. In the context of the present application, "laterally" means parallel to the device plane. Here, the first insulating layer may consist of the first insulating layer portions.

The power semiconductor device may comprise a second insulating layer, which is arranged at a side of the gate electrode layer facing away from the first main electrode. Exemplarily, the second insulating layer comprises SiO2. Moreover, the second insulating layer may be a spin-on-glass (SOG) layer. The second insulating layer decreases a parasitic capacitance of the gate electrode layer.

According to at least one embodiment of the power semiconductor device, for example if the power semiconductor device has a planar MOSFET design like a VDMOS design, the channel layers are arranged in a plane different from a plane of the gate electrode layer, and the first insulating layer comprises second insulating layer portions arranged on a side of the gate electrode layer facing the second main electrode. Even more, the first insulating layer may consist of the second insulating layer portions. For example, the second insulating layer portions have a planar configuration. Here, the first conductivity type and the second conductivity type may be different, and a drain layer of the first conductivity type may be arranged on sides of the channel layers facing away from the contact layers. Exemplarily, the drain layer comprises 4H-SiC or 6H-SiC. Moreover, the power semiconductor device may only comprise fin-shaped regions.

According to at least one embodiment, the power semiconductor device comprises an intermediate insulating layer arranged between the gate electrode layer and the contact layer of each pillar-shaped or fin-shaped region at least on the side of the gate electrode layer facing the first main electrode. Exemplarily, the intermediate insulating layer comprises SiO2. Moreover, the second insulating layer may be a spin-on-glass (SOG) layer.

As mentioned above, the channel layer may comprise 3C-SiC and the drain layer may comprise 4H-SiC or 6H-SiC. Here, the idea is to combine the advantages of two SiC polytypes, i.e. 3C-SiC and 4H-SiC or alternatively 3C-SiC and 6H-SiC, to enable high performance SiC power devices. Whereas 4H-SiC or alternatively 6H-SiC employed in the drain layer ensures good blocking capability due to its higher band gap, 3C-SiC is employed as a channel material, since channel motilities exceeding 160 cm2/vs have been measured in 3C-SiC. In the case of SiC, near interface traps (NITs) are an important class of interface defects, which can be found inside the oxide very close to the interface in Si and SiC MOS structures. In the latter, they are responsible for the high concentration of neutral defect states near the conduction band edge (EC-ET<0.2 eV) as shown in Fig. 2. However, the distribution and density of NITs strongly depend on the polytype of SiC. While the density of NITs increases nearly exponentially towards the conduction band edge for 4H-SiC or 6H-SiC, it remains relatively low for 3C-SiC. In addition, defect states in the lower half of the band gap (close to the valence band, see Fig. 2) are donor-like and do not directly affect the n-type carrier mobility. Defect states near the conduction band, however, are acceptor-like and can be negatively charged, for instance if a gate voltage is applied. As a consequence, electrons in the inversion channel are trapped, become almost immobile and act as coolant scattering centers, which significantly limits the n-channel mobility. Therefore, 3C-SiC/oxide interfaces in power MOSFET devices exhibit lower interface defect density Dit and as a consequence higher channel mobility compared to their 4H-SiC/oxide or 6H-SiC/oxide counterparts.

In an exemplary embodiment, the power semiconductor device comprises a carrier, on which the semiconductor layer stack is arranged. The carrier may be a substrate or substrate layer onto which the semiconductor layer stack has been epitaxially grown.

According to at least one embodiment, the power semiconductor device is a power device. For example, the power semiconductor device is configured for a maximum current through the channel layer of at least 10 A or of at least 50 A. As an option, the maximum current is at most 500 A. Alternatively or additionally, the power semiconductor device is configured for a maximum voltage of at least 0.65 kV or of at least 1.2 kV. As an option, the maximum voltage may be at most 6.5 kV.

The power semiconductor device is, for example, intended for a power module in a vehicle to convert direct current from a battery to alternating current for an electric motor, for example in hybrid vehicles or plug-in electric vehicles.

A method for manufacturing a power semiconductor device according to any one of the preceding embodiments comprises the following:
- providing a substrate,
- forming a sacrificial layer on a first main side of the substrate,
- structuring the sacrificial layer to form a plurality of sacrificial structures protruding from the first main side and having the shape of a pillar or a fin,
- forming an insulating material layer on at least one, exemplarily each, of the plurality of sacrificial structures and the first main side, wherein at least a part of the insulating material layer forms the first insulating layer in the power semiconductor device,
- removing at least one, exemplarily each, sacrificial structure to form at least one cavity, exemplarily a plurality of cavities, in the insulating material layer,
- forming the gate electrode layer on a second portion or second portions of the insulating material layer which form(s) the at least one second insulating layer portion in the power semiconductor device,
- forming a semiconductor layer of the first conductivity-type selectively on the first main side to form a contact layer in the at least one, exemplarily each, cavity extending to a side of the gate electrode layer facing away from the substrate,
- forming the first main electrode on a side of the semiconductor layer stack facing away from the substrate,
- forming the second main electrode on a side of the semiconductor layer stack facing away from the first main electrode.

For example, document US 2011/0124169 A1 refers to methods of selectively depositing an epitaxial layer.

Compared to the methods for manufacturing SiC based trench-type power MOSFETs no step of etching a deep trench in SiC is required in the above-described method. This facilitates manufacturing in view of the difficulties to form deep trenches in SiC by etching.

In an exemplary embodiment the sacrificial layer comprises amorphous silicon. Each sacrificial structure may have a vertical extension in a vertical direction perpendicular to the first main side in a range between 50 nm and 10 µm, exemplarily in a range between 5 and 10 µm.

In an exemplary embodiment, the insulating material layer is formed by thermal oxidation of the sacrificial structures. Thermal oxidation allows to form the insulating material layer with very stable oxide material providing good properties for the gate insulating layer and having good mechanical characteristics, which is advantageous for use of the insulating material layer as a gate dielectric.

Processes for removing portions of the insulating material layer may include masking and etching techniques.

According to at least one embodiment, the method comprises forming the semiconductor layer of the first conductivity-type, which is provided to form the contact layers, after producing the gate electrode layer. This refers to a so-called 'gate-first' integration, where the gate electrode layer and even more layers like the second insulating layer and the intermediate insulating layer are deposited before selectively forming/growing the pillar-shaped or fin-shaped regions. However, it is also possible to selectively grow the pillar-shaped or fin-shaped regions before producing the gate electrode layer and possibly the second insulating layer and the intermediate insulating layer.

According to at least one embodiment, the method comprises selectively forming a semiconductor layer of the second conductivity-type on the first main side in each cavity between the contact layers and the substrate to form the channel layers. This embodiment is suited for realizing a MOSFET or ACCUFET design of the power semiconductor device.

According to at least one embodiment, the method comprises selectively forming a semiconductor layer of the first conductivity-type on the first main side in each cavity between the channel layers and the substrate to form the drain layers. This embodiment is suited for realizing a MOSFET design of the power semiconductor device.

In an exemplary embodiment, forming the semiconductor layer of the first conductivity-type to form the contact layers is respectively performed at a temperature below 1400°C. Temperatures above 1400°C may damage the insulating material layer, which is used as a gate dielectric in the power semiconductor device. For example, a silicon oxide material is damaged at temperatures above 1400°C. Forming other semiconductor layers of the semiconductor layer stack may be respectively performed at a temperature below 1400°C, too.

In an exemplary embodiment the method comprises forming a second insulating layer on the insulating material layer before forming the gate electrode layer, such that after forming the gate electrode layer, the second insulating layer is sandwiched in a vertical direction perpendicular to the first main side between the insulating material layer and the gate electrode layer. Exemplarily, the second insulating layer is a spin-on-glass (SOG) layer.

The method described above is suitable for the production of power semiconductor devices described here. Features described in connection with the power semiconductor device thus also apply to the method and vice versa.

A power semiconductor device and a method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist understanding.

In the figures:
- Figure 1: illustrates the performance of state-of-the-art 4H-SiC power MOSFETs,
- Figure 2: illustrates the distribution of interface states inside the band gap of various SiC polytypes,
- Figures 3A, 3C and 3D: show schematic perspective views, Figures 3B and 3F show schematic cross-sectional views and Figure 3E shows a top view of a first exemplary embodiment of a power semiconductor device,
- Figures 4A, 4C and 4D: show schematic perspective views and Figure 4B shows a schematic cross-sectional view of a second exemplary embodiment of a power semiconductor device,
- Figure 5: shows a schematic cross-sectional view of a third exemplary embodiment of a power semiconductor device,
- Figures 6A and 6B: show schematic cross-sectional views of a forth exemplary embodiment of a power semiconductor device,
- Figures 7A to 7F: illustrate a method for manufacturing a semiconductor power device according to one of the first to third exemplary embodiments,
- Figures 8A to 8E: illustrate a method for manufacturing a semiconductor power device according to the forth exemplary embodiment.

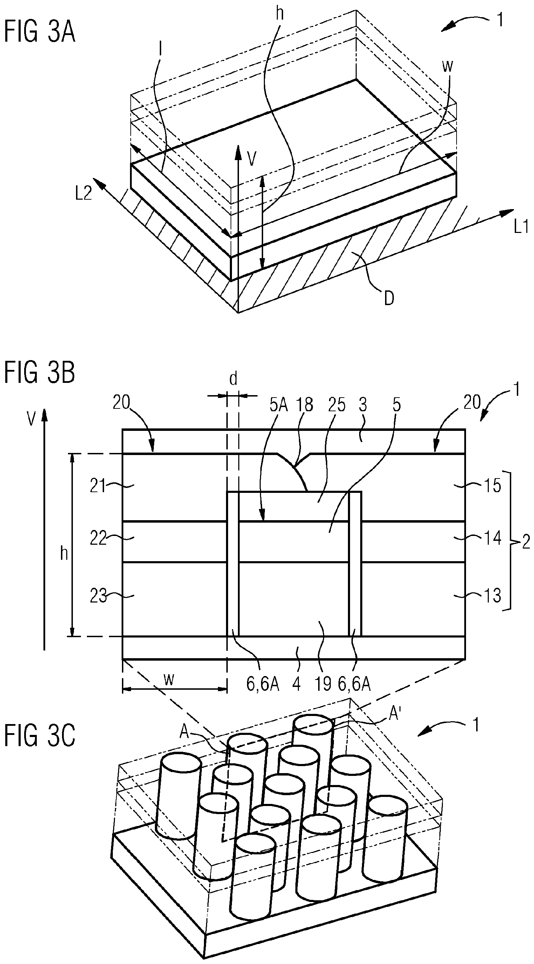

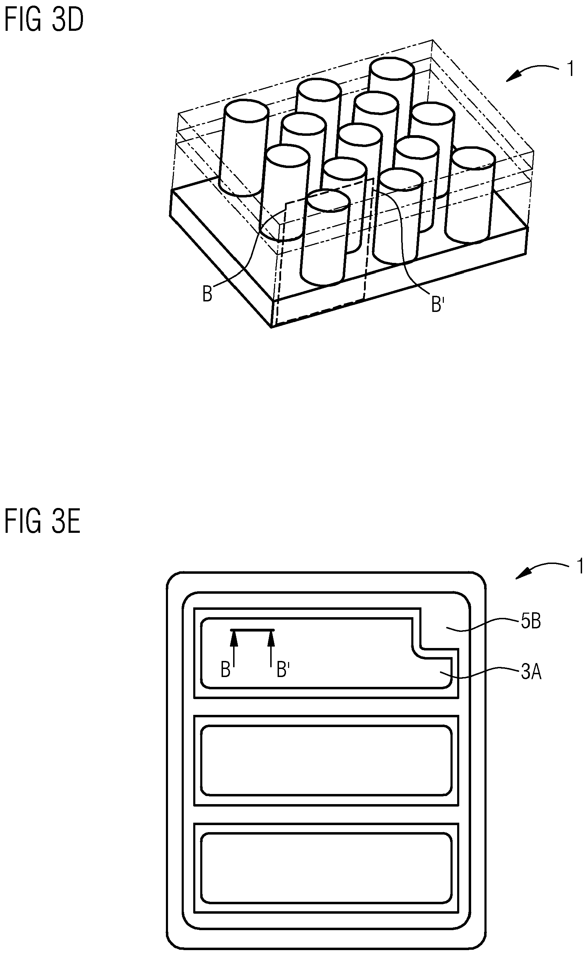

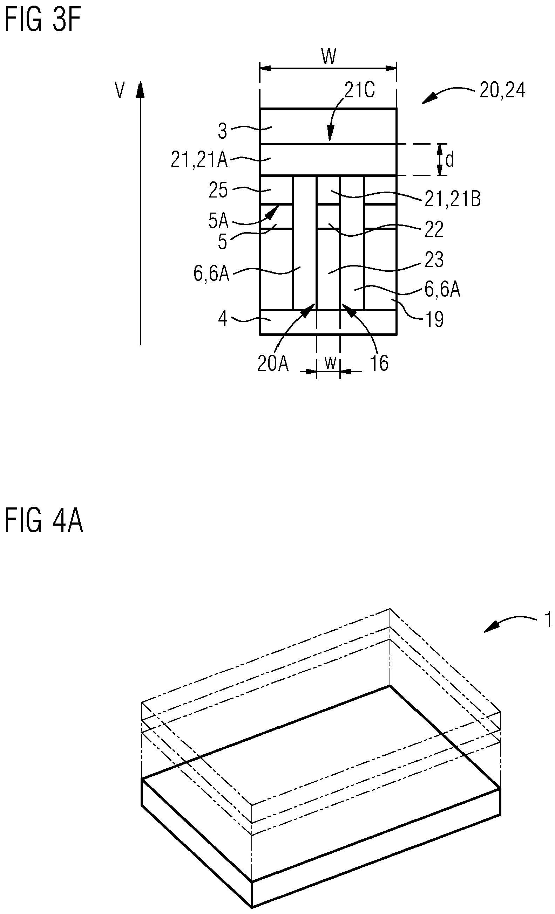

Figures 3A to 3F show different schematic views of a first exemplary embodiment of a power semiconductor device 1, wherein Figure 3B is a cross-sectional view taken along plane A-A' shown in Figure 3C, and Figure 3F is a cross-sectional view taken along plane B-B' shown in Figure 3D.

The power semiconductor device 1 according to the first exemplary embodiment has a cuboid shape defined by a first lateral extension w along a first lateral extension direction L1, a second lateral extension 1 along a second lateral extension direction L2 perpendicular to the first lateral extension direction L1 and a vertical extension h in a vertical direction V perpendicular to a device plane D spanned by the first lateral extension direction L1 and the second lateral extension direction L2 (see Figure 3A).

The power semiconductor device 1 comprises a first main electrode 3, a second main electrode 4 and a semiconductor layer stack 2 between and in electrical contact with the first main electrode 3 and the second main electrode 4 (see Figures 3A and 3B). The semiconductor layer stack 2 is sandwiched in the vertical direction V between the first main electrode 3 and the second main electrode 4. "In electrical contact" means that during operation, for example in an on-state of the power semiconductor device 1, a current flows through the semiconductor layer stack 2 between the first main electrode 3 and the second main electrode 4. The first and the second main electrodes 3, 4 are, for example, metallic electrodes. The first main electrode 3 may be a source electrode and the second main electrode 4 may be a drain electrode. The power semiconductor device 1 has a MOSFET design.

As becomes evident from Figure 3B, the semiconductor layer stack 2 comprises differently doped semiconductor layers 13, 14, 15 stacked one on top of the other in the vertical direction V, wherein semiconductor layer 15 is highly n-doped and has a first doping concentration, semiconductor layer 14 is highly p-doped and has a second doping concentration and semiconductor layer 13 is n-doped and has a third doping concentration, which is less than that of semiconductor layer 15. For example, the first doping concentration may exceed the third doping concentration, exemplarily by at least a factor of 10. For example, the first doping concentration may range between 10¹⁹ and 10²⁰ cm⁻³, whereas the third doping concentration may range between 10¹⁶ and 10¹⁷ cm⁻³. Moreover, the second doping concentration may range between 10¹⁶ and 10¹⁸ cm⁻³.

The semiconductor layers 13, 14, 15 are each discontinuous layers.

The semiconductor layer stack 2 is based on silicon carbide, which means that at least one of the semiconductor layers 13, 14, 15 of the semiconductor layer stack 2 comprises or consists of SiC. The semiconductor layers 13, 14, 15 may be of any SiC polytype. Layers 13, 14, 15 may be of different SiC polytypes or of the same SiC polytype. In an exemplary embodiment, layer 15 and layer 14 may each comprise 3C-SiC whereas layer 13 may comprise 4H-SiC or 6H-SiC.

The power semiconductor device 1 comprises a gate electrode layer 5 between the first main electrode 3 and the second main electrode 4, wherein "between" in this case means sandwiched in the vertical direction V (see Figure 3B). The gate electrode layer 5 may be a highly doped Si layer or a metal layer, for example a layer of Al.

The power semiconductor device 1 comprises a first insulating layer 6 comprising a plurality of first insulating layer portions 6A traversing the gate electrode layer 5. The first insulating layer 6 contains or consists of at least one of silicon dioxide or silicon nitride. Exemplarily, the first insulating layer 6 is a thermal oxide layer. A layer thickness d of the first insulating layer 6 is exemplarily in a range between 5 and 500 nm, wherein the layer thickness d designates a maximum extent in a direction parallel to a surface normal of the first insulating layer 6.

Moreover, as becomes evident from Figures 3C and Figures 3D, the semiconductor layer stack 2 comprises a plurality of pillar-shaped regions 20, which traverse the gate electrode layer 5 and each comprise a contact layer 21 arranged at the first main electrode 3 with a first doping concentration and with a first conductivity type, wherein each contact layer 21 is a part of the semiconductor layer 15 and thus has the same qualities as described in connection with the semiconductor layer 15. For example, the contact layers 21 serve as source layers of the power semiconductor device 1. Moreover, each of the plurality of pillar-shaped regions 20 comprises a part of semiconductor layer 14 and semiconductor layer 13, wherein the parts of semiconductor layer 14 are channel layers 22 and the parts of semiconductor layer 13 are drain layers 23 of the power semiconductor device 1. The channel layers 22 are arranged in a common plane with the gate electrode layer 5.

The pillar-shaped regions 20 may have a vertical extension h larger than their lateral extension w. Exemplarily, the vertical extension h might be at least 2 or 3 times larger than the lateral extension w.

As illustrated in Figure 3D the plurality of pillar-shaped regions 20 may be arranged in form of a matrix. The number of pillar-shaped regions 20 is not restricted to the one shown in the Figures, but may exceed this number or fall below this number.

Each contact layer 21 extends to a side 5A of the gate electrode layer 5 facing the first main electrode 3. As becomes evident from Figure 3B, the contact layers 21 of adjacent pillar-shaped regions 20 are arranged continuously on the side of the gate electrode layer 5 facing the first main electrode 3. The continuously arranged contact layers 21 allow for a mainly planar surface of the semiconductor layer stack 2 facing the first main electrode 3, which simplifies the application of the first main electrode 3.

An overlapping area 18, where the contact layers 21 of adjacent pillar-shaped regions 20 merge on the side 5A of the gate electrode layer 5 facing the first main electrode 3, may comprise defects in the semiconductor material which are detectable, for example, by TEM ("Transmission Electron Microscopy").

As becomes evident from Figure 3F, the contact layer 21 comprises a first portion 21A extending to the side 5A of the gate electrode layer 5 facing the first main electrode 3 and a second portion 21B arranged in a cavity 16 of the first insulating layer portion 6A, which may be tube-shaped. If the contact layer 21 does not extend laterally beyond the cavity 16, a contact area of the contact layer 21 is defined by a lateral extension w of the cavity 16, which is below 2 µm, exemplarily below 1 µm. However, by extending the contact layer 21 laterally to the side 5A of the gate electrode layer 5 facing the first main electrode 3, the contact area 21C is defined by the lateral dimension w of the second portion 21B, which may result in an increase of the contact area 21C by a factor of at least 2 and thus in a reduction of the source resistance R_{S}. The contact area 21C may amount to 10 mm² to 20 mm². The layer thickness d of the first portion 21A of the contact layer 21 may amount to several hundred nanometers, for example 100 nm to 500 nm.

The first insulating layer portions 6A respectively extend directly on lateral surfaces 20A of the plurality of pillar-shaped regions 20. The plurality of first insulating layer portions 6A laterally cover and laterally surround the drain layer 23, the channel layer 22 and the first portion 21A of the contact layer 21. The gate electrode layer 5 is a continuous layer laterally surrounding each pillar-shaped region 20.

A second insulating layer 19 is sandwiched in the vertical direction V between the second main electrode 4 and the gate electrode layer 5. The second insulating layer 19 separates the gate electrode layer 5 from the second main electrode 4 to minimize a parasitic capacitance of the gate electrode layer 5. The second insulating layer 19 may be of any electrically insulating material. For example, it may be a spin-on-glass (SOG) layer.

In the first exemplary embodiment each transistor cell 24 comprises one of the plurality of pillar-shaped regions 20, one of the plurality of first insulating layer portions 6A and a portion of the gate electrode layer 5 as described above to form a vertical gate-all-around field effect transistor cell.

As shown in Figures 3B and 3F, the power semiconductor device 1 comprises an intermediate insulating layer 25 arranged on the gate electrode layer 5, and the first main electrode 3 is arranged on the intermediate insulating layer 25. The first main electrode 3 is separated from the gate electrode layer 5 by the intermediate insulating layer 25 to be electrically insulated therefrom.

Referring to Figure 3E, an upper portion of the first main electrode 3 is a source contact pad 3A and is serving as a source terminal of the power semiconductor device 1. Alternatively, the source contact pad 3A may be implemented as a separate element electrically connected to the first main electrode 3. The gate electrode layer 5 extending below the first main electrode 3 is electrically connected to a control contact pad 5B serving as a gate terminal of the power semiconductor device 1. In the first exemplary embodiment, the control contact pad 5B is arranged lateral to the source contact pad 3A. This means that while the contact layers 21 are connected to the source contact pad 3A from the top, the gate electrode layer 5 is connected to the control contact pad 5B from a lateral side of the power semiconductor device 1, i.e. in an orthogonal projection onto the device plane D, the source contact pad 3A overlaps the plurality of transistor cells 24 while the control contact pad 5B is arranged lateral to the plurality of transistor cells 24.

The power semiconductor device 1 according to the first exemplary embodiment is free of a carrier.

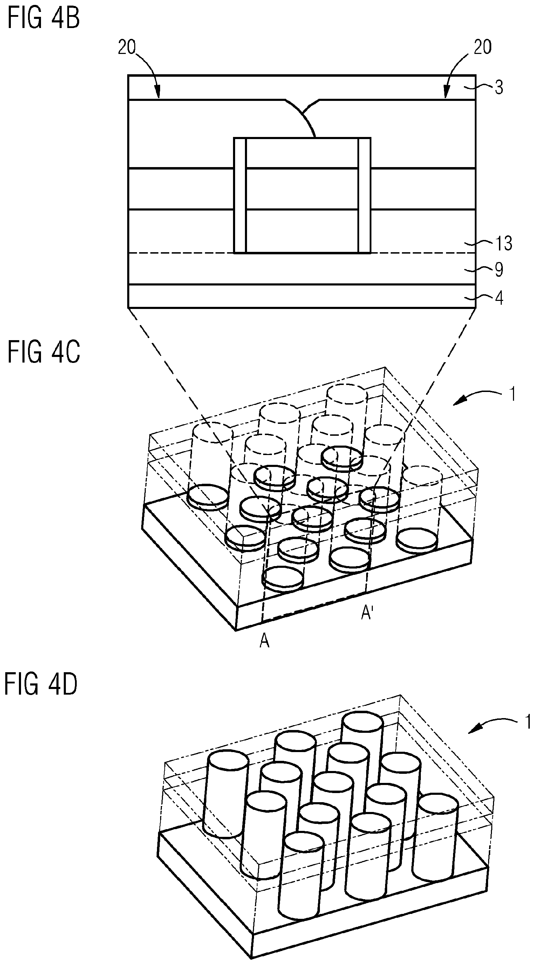

A second exemplary embodiment of a power semiconductor device 1 is shown in Figures 4A to 4D, wherein Figure 4B is a cross-sectional view taken along plane A-A' shown in Figure 4C.

The second exemplary embodiment is similar to the first exemplary embodiment described in connection with Figures 3A to 3F. Therefore, the above explanations also apply to the second exemplary embodiment. There is a difference in that the power semiconductor device 1 according to the second exemplary embodiment comprises a first substrate layer 9 between the pillar-shaped regions 20 and the second main electrode 4. The first substrate layer 9 may be formed of the same material as semiconductor layer 13. The first substrate layer 9 may serve to grow the semiconductor layer stack 2 in the production process. The first substrate layer 9 may serve as a drift layer of the power semiconductor device 1.

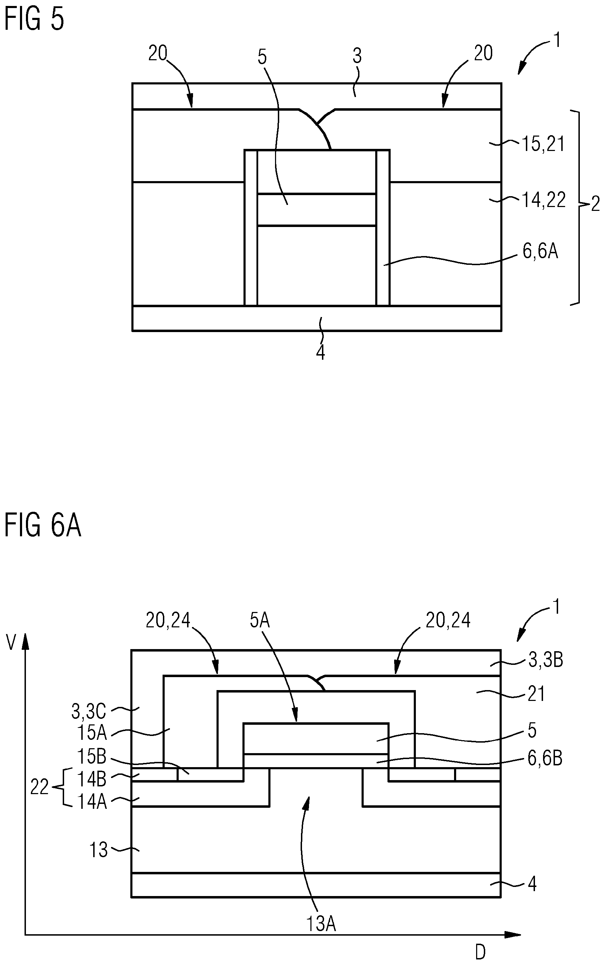

Figure 5 shows a cross-sectional view of a third exemplary embodiment of a power semiconductor device 1. The second exemplary embodiment has similarities to the first exemplary embodiment described in connection with Figures 3A to 3F. Therefore, the above explanations also apply to the third exemplary embodiment.

There is a difference in that the pillar-shaped regions 20 of the power semiconductor device 1 according to the third exemplary embodiment each comprise a channel layer 22 having a second conductivity type which is the same as the first conductivity type, for example n-type. So, the pillar-shaped regions 20 and the semiconductor layer stack 2 are of only one conductivity type. For example, the semiconductor layer stack 2 consists of n-doped 3C SiC. The power semiconductor device 1 is designed as an ACCUFET device.

The contact layer 21 is highly n-doped with a first doping concentration of, for example, 10¹⁹ to 10²⁰ cm⁻³. Compared with that, the channel layer 22 is weakly doped with a lower second doping concentration of, for example, 10¹⁶ to 10¹⁷ cm⁻³.

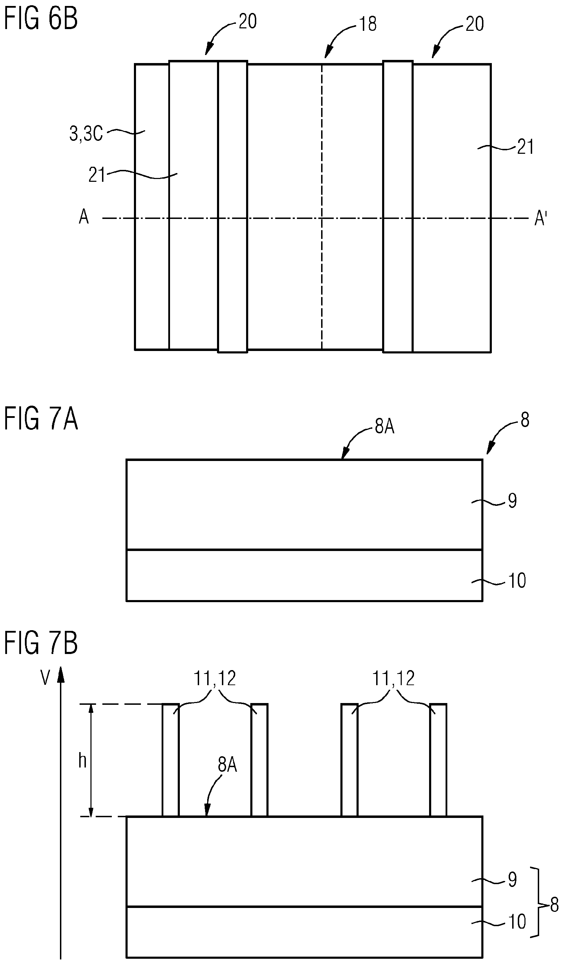

Figures 6A and 6B show different schematic views of transistor cells 24 of a forth exemplary embodiment of a power semiconductor device, wherein Figure 6A is a cross-sectional view taken along plane A-A' shown in Figure 6B.

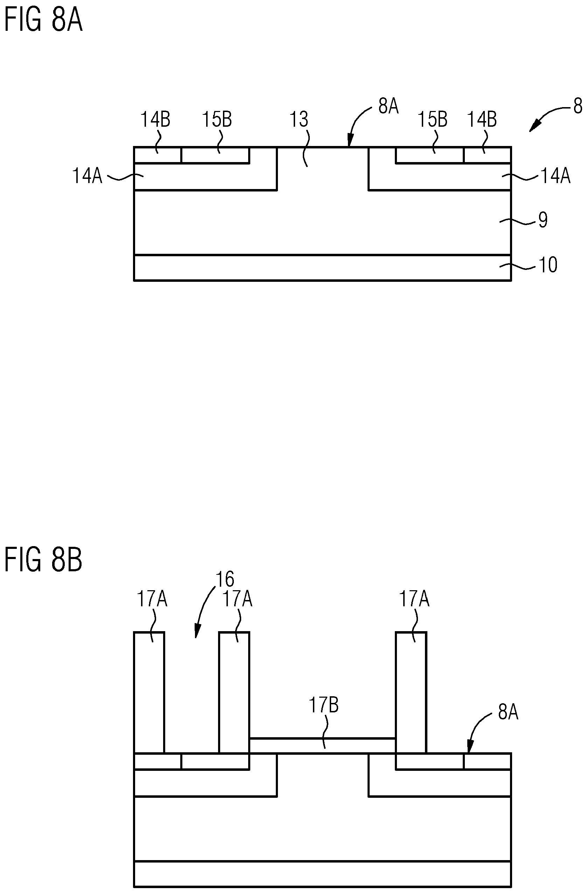

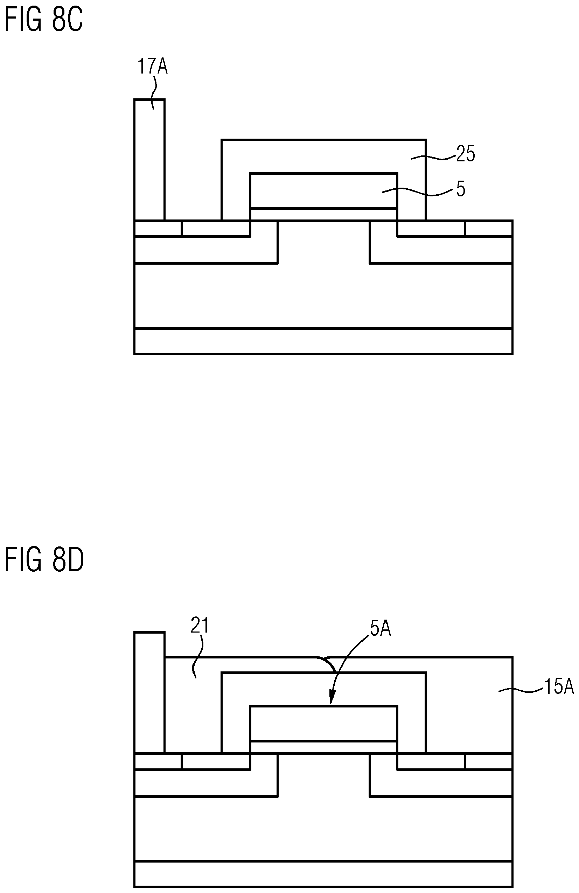

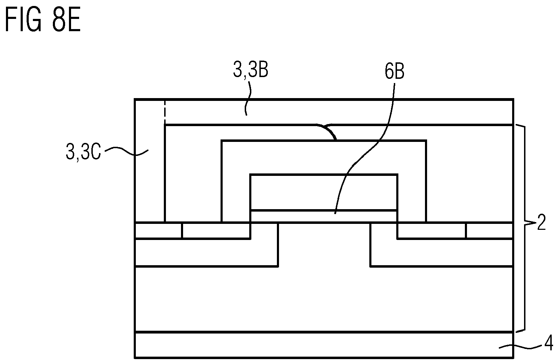

The power semiconductor device comprises a first main electrode 3, a second main electrode 4 and a semiconductor layer stack 2 between and in electrical contact with the first main electrode 3 and the second main electrode 4. The first main electrode 3 comprises a first portion 3B arranged in parallel to the second main electrode and a second portion 3C arranged obliquely, for example perpendicularly, to the first portion 3B. When producing the power semiconductor device, an insulating material layer 17 used to form the first insulating layer 6 may be formed with first portions 17A and second portions 17B (see Figure 8B). The first portions 17A may be removed, and the second portions 3C of the first main electrode 3 may be produced at vacancies of the removed first portions 17A (see Figure 8E).

The power semiconductor device further comprises a gate electrode layer 5, which is sandwiched in the vertical direction V between the first portion 3B of the first main electrode 3 and the second main electrode 4.

And the power semiconductor device comprises a first insulating layer 6 consisting of a plurality of second insulating layer portions 6B arranged on a side of the gate electrode layer 5 facing the second main electrode 4. The second insulating layer portions 6B have a planar configuration.

The power semiconductor device is a planar MOSFET and has the design of a vertical double diffusion metal oxide semiconductor structure (VDMOS).

The semiconductor layer stack 2 comprises differently doped semiconductor layers 15A, 15B, 14A, 14B, 13, wherein layers 15A, 15B and 13 are of the same first conductivity type, for example n-type, and wherein the doping concentration of layer 15A is higher than the doping concentration of layer 15B. Moreover, layers 14A and 14B are of the same second conductivity type, for example p-type, wherein the doping concentration of layer 14A is lower than the doping concentration of layer 14B. Layers 14B and 15B are arranged next to each other in a plane parallel to the device plane D. For example, semiconductor layer 15A is an n⁺⁺-SiC layer, semiconductor layer 15B is an n⁺-SiC layer, semiconductor layer 14B is a p⁺-SiC layer, semiconductor layer 14A is a p-SiC layer and semiconductor layer 13 is an n-SiC layer.

The power semiconductor device comprises a plurality of fin-shaped regions 20, which traverse the gate electrode layer 5 and which each comprise a contact layer 21 arranged at the first main electrode 3, wherein each contact layer 21 extends to a side 5A of the gate electrode layer 5 facing the first main electrode 3. The fin-shaped regions 20 may consist of the contact layers 21.

Each contact layer 21 is a part of the semiconductor layer 15A and thus has the same qualities as described in connection with the semiconductor layer 15A. Each contact layer 21 is arranged on a part of semiconductor layer 15B, said part forming a source layer with the contact layer 21.

Moreover, a channel layer 22 is assigned to one fin-shaped region 20 and is arranged at a side of the contact layer 21 facing away from the first main electrode 3, wherein the channel layer 22 comprises a part of semiconductor layer 14A and a part of semiconductor layer 14B, and wherein the part of semiconductor layer 14B is arranged between the second portion 3C of the first main electrode 3 and the part of semiconductor layer 14A. Two adjacent channel layers 22 are laterally separated by a ridge region 13A of semiconductor layer 13, which forms a common drain layer for all transistor cells 24. The channel layers 22 are arranged in a plane different from a plane of the gate electrode layer 5. And the drain layer 13 is arranged on a side of the channel layers 22 facing away from the contact layers 21. Exemplarily, the drain layer comprises 4H-SiC or 6H-SiC. The first insulating layer 6 is arranged between the gate electrode layer 5 and the channel layers 22 such that the gate electrode layer 5 is electrically separated from each one of the channel layers 22.

In connection with Figures 7A to 7F, a method for manufacturing a power semiconductor device 1 according to any one of the first to third exemplary embodiments is described.

The method comprises providing a substrate 8 comprising a first substrate layer 9 and a second substrate layer 10. The first substrate layer 9 may be deposited onto the second substrate layer 10 by a chemical vapour deposition (CVD) process, for example. Alternatively, the two-layered structure of the substrate 8 may be formed by implantation of an n-type dopant into an n-type preliminary substrate to form the first substrate layer 9 and the second substrate layer 10 having different doping concentrations. For example, the second substrate layer 10 may be a 4H-SiC n⁺-layer and the first substrate layer 10 may be a 4H-SiC n-layer.

The method further comprises forming a sacrificial layer 11 on a first main side 8A of the substrate 8 and structuring it to form a plurality of sacrificial structures 12 protruding from the first main side 8A and having a shape of a pillar or a fin (see Figure 7B). The sacrificial layer 11 may be a poly-silicon (poly-Si) layer or an amorphous silicon layer. Exemplarily each sacrificial structure 12 has a vertical extension h in the vertical direction V perpendicular to the first main side 8A in a range between 50 nm and 10 µm, exemplarily in a range between 5 µm and 10 µm (see Fig. 7B).

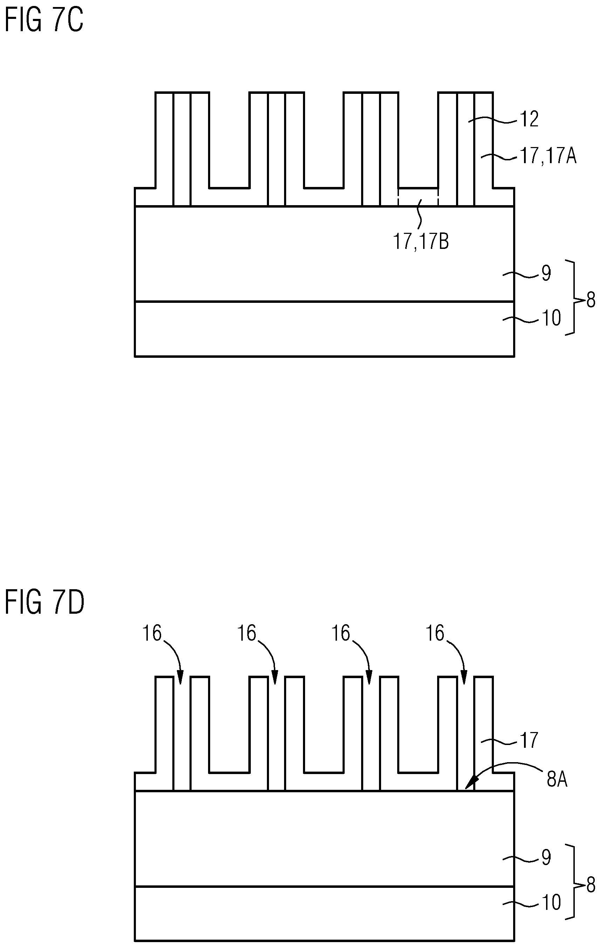

The method further comprises forming an insulating material layer 17 on the plurality of sacrificial structures 12 and on the first main side 8A comprising first portions 17A to form the first insulating layer portions 6A in the power semiconductor device and comprising second portions 17B to form the second insulating layer portions 6B in the power semiconductor device (see Fig. 7C). The insulating material layer 17 may be a thermal oxide layer formed by thermal oxidation of the sacrificial structures 12 and of exposed portions of the first substrate layer 9. Alternatively, the insulating material layer 17 can be formed by a deposition process such as by plasma enhanced CVD (PE-CVD) or another appropriate deposition process. Exemplarily, the insulating material layer 17 is a silicon oxide or a silicon nitride layer.

The method further comprises removing the sacrificial structures 12 to form a plurality of cavities 16 in the insulating material layer 17 (see Fig. 7D). The sacrificial structures 12 may be removed by selective etching.

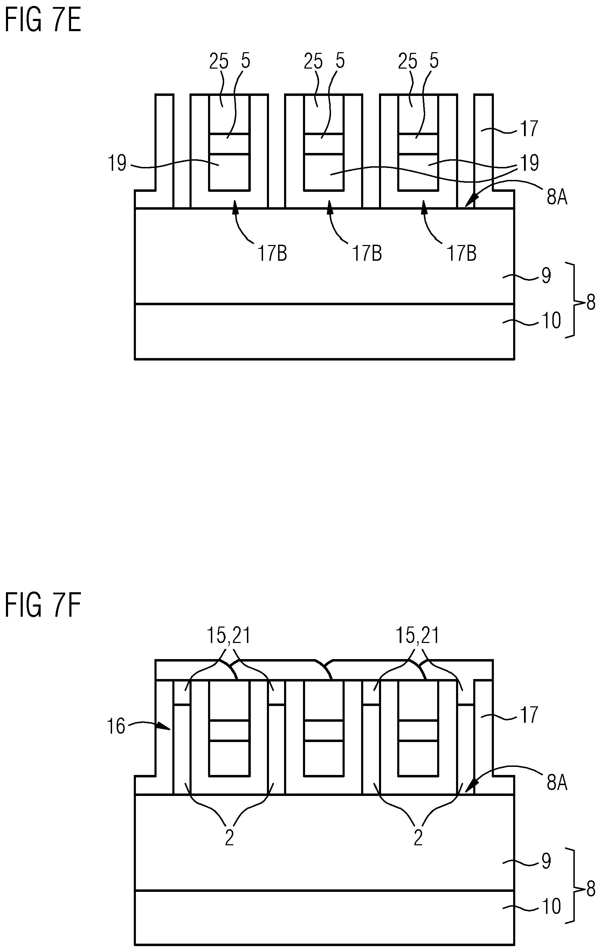

The method further comprises forming the gate electrode layer 5 on a second portion 17B of the insulating material layer 17 which forms the second insulating layer portion 6B of the insulating layer 6 in the power semiconductor device. Before forming the gate electrode layer 5, a second insulating layer 19 may be formed on that part of the insulating material layer 17 which forms the at least one second insulating layer portion 6B of the insulating layer 6. Moreover, an intermediate insulating layer 25 may be formed on a side of the gate electrode layer 5 facing away from the substrate 8 (see Figure 7E).

Moreover, a semiconductor layer stack 2 is formed comprising forming a semiconductor layer 15 of the first conductivity-type selectively on the first main side 8A to form a contact layer 21 in each cavity 16 such that it extends to a side of the gate electrode layer 5 facing away from the substrate 8 (see Figure 7F). In the "gate-first" integration, forming the semiconductor layer stack 2 is performed after forming the gate electrode layer 5.

Forming the semiconductor layer stack 2 further comprises forming a semiconductor layer 14 of the second conductivity-type selectively on the first main side 8A in each cavity 16 between the contact layers 21 and the substrate 8 to form the channel layers 22.

Forming the semiconductor layer stack 2 to manufacture a semiconductor power device according to the first and second exemplary embodiments further comprises forming a semiconductor layer 13 of the first conductivity-type selectively on the first main side 8A in each cavity 16 between the channel layers 22 and the substrate 8 to form drain layers 23.

Moreover, the first main electrode 3 may be formed on a side of the semiconductor layer stack 2 facing away from the substrate 8. And the second main electrode 4 may be formed on a side of the semiconductor layer stack 2 facing away from the first main electrode 3 (not shown). Before forming the second main electrode 4, the substrate 8 and the at least one second portion 17B of the insulating material layer 17 as well as the part of the semiconductor layer stack 2 being laterally surrounded by the second portion 17B may be removed.

In connection with Figures 8A to 8E, a second exemplary embodiment of a method for producing a power semiconductor device 1 is described, said method being suitable for producing the power semiconductor device according to the forth exemplary embodiment.

As shown in Figure 8A, the method comprises providing a substrate 8, wherein the substrate 8 comprises a first substrate layer 9 and a second substrate layer 10. Here, the first substrate layer 9 comprises semiconductor layers 15B, 14A, 14B, 13 of the semiconductor layer stack 2.

The method further comprises forming a sacrificial layer on a first main side 8A of the substrate 8 and structuring the sacrificial layer to form a plurality of sacrificial structures (as shown in Figure 7B, for example) protruding from the first main side 8A and having the shape of a fin. Moreover, an insulating material layer (as shown in Figure 7C, for example) is formed on the plurality of sacrificial structures and on the first main side 8A, wherein at least a part of the insulating material layer forms the first insulating layer in the power semiconductor device 1. And each sacrificial structure is removed to form a plurality of cavities 16 in the insulating material layer (see Figure 8B).

The method further comprises forming the gate electrode layer 5 on second portions 17B of the insulating material layer 17 which form the second insulating layer portions 6B of the insulating layer 6 in the power semiconductor device (see Figure 8E). An intermediate insulating layer 25 is formed over the gate electrode layer 5 covering its side facing away from the substrate 8 as well as lateral surfaces of the gate electrode layer 5. Before forming the intermediate insulating layer 25, the first portions 17A of the insulating material layer 17 adjacent to the second portions 17B of the insulating material layer 17 may be removed.

The method further comprises selectively forming a semiconductor layer 15A of the first conductivity-type on the first main side 8A to form a contact layer 21 in each cavity 16 such that it extends to a side 5A of the gate electrode layer 5 facing away from the substrate 8 (see Figure 8D).

The method further comprises forming first portions 3B of the first main electrode 3 on a side of the semiconductor layer stack 2 facing away from the substrate 8 (see Figure 8E). And second portions 3C of the first main electrode 3 are formed at vacancies, where first portions 17A of the insulating material layer 17 adjacent to the contact layers 21 have been removed.

The method further comprises forming the second main electrode 4 on a side of the semiconductor layer stack 2 facing away from the first main electrode 3 (see Figure 8E). Before forming the second main electrode 4, the second substrate layer 10 may be removed.

The exemplary embodiments described in this disclosure are is not restricted by the description given with reference to the exemplary embodiments. Rather, it is contemplated that the disclosure encompasses any novel feature and any combination of features, including in particular any combination of features in the claims, even if this feature or this combination is not itself explicitly indicated in the claims or exemplary embodiments.

### List of reference signs

1 semiconductor power device
2 semiconductor layer stack
3 first main electrode
3A source contact pad
3B first portion of first main electrode
3C second portion of first main electrode
4 second main electrode
5 gate electrode layer
5A side of the gate electrode layer facing the first main electrode
5B control contact pad
6 first insulating layer
6A first insulating layer portion
6B second insulating layer portion
7 carrier
8 substrate
8A first main side of the substrate
9 first substrate layer
10 second substrate layer
11 sacrificial layer
12 sacrificial structure
13, 14A, 14B, 15A, 15B semiconductor layer
13A ridge region
16 cavity
17 insulating material layer
17A first portion of insulating material layer
17B second portion of insulating material layer
18 overlapping area
19 second insulating layer
20 pillar-shaped or fin-shaped region
20A lateral surface of pillar-shaped or fin-shaped region
21 contact layer
21A first portion of contact layer
21B second portion of contact layer
21C contact area
22 channel layer
23 drain layer
24 transistor cell
25 intermediate insulating layer

d layer thickness
w first lateral extension
1 second lateral extension
h vertical extension
D device plane
L1 first lateral extension direction
L2 second lateral extension direction
V vertical direction

## Claims

1. A power semiconductor device (1) comprising:
- a first main electrode (3),
- a second main electrode (4),
- a gate electrode layer (5) between the first main electrode (3) and the second main electrode (4),
- a first insulating layer (6) comprising at least one of a plurality of first insulating layer portions (6A) traversing the gate electrode layer (5) and of at least one second insulating layer portion (6B) arranged on a side of the gate electrode layer (5) facing the second main electrode (4),
- a semiconductor layer stack (2) between and in electrical contact with the first main electrode (3) and the second main electrode (4), the semiconductor layer stack (2) comprising:
- silicon carbide,
- differently doped semiconductor layers (13, 14A, 14B, 15A, 15B), wherein at least two semiconductor layers (13, 14A, 14B, 15A, 15B) differ in at least one of their conductivity type and their doping concentration,
- a plurality of pillar-shaped or fin-shaped regions (20), which traverse the gate electrode layer (5) and which each comprise a contact layer (21) arranged at the first main electrode (3) with a first doping concentration and with a first conductivity type,
wherein
each contact layer (21) extends to a side (5A) of the gate electrode layer (5) facing the first main electrode (3).

2. The power semiconductor device (1) according to the preceding claim, wherein the contact layers (21) of adjacent pillar-shaped or fin-shaped regions (20) merge on the side of the gate electrode layer (5) facing the first main electrode (3).

3. The power semiconductor device (1) according to any one of the preceding claims, wherein the semiconductor layer stack (2) comprises a plurality of channel layers (22) each assigned to one pillar-shaped or fin-shaped region (20) and arranged at sides of the contact layers (21) facing away from the first main electrode (3).

4. The power semiconductor device (1) according to the preceding claim, wherein the channel layers (22) have a second doping concentration and a second conductivity type, wherein at least one of
- the second doping concentration differs from the first doping concentration and
- the second conductivity type differs from the first conductivity type.

5. The power semiconductor device (1) according to any one of the two preceding claims, wherein the first insulating layer (6) is arranged between the gate electrode layer (5) and the channel layers (22) such that the gate electrode layer (5) is electrically separated from each one of the channel layers (22).

6. The power semiconductor device (1) according to the preceding claim, wherein the channel layers (22) are at least partly arranged in a common plane with the gate electrode layer (5), and the first insulating layer (6) comprises first insulating layer portions (6A) extending on lateral surfaces of the pillar-shaped or fin-shaped regions (20).

7. The power semiconductor device (1) according to the preceding claim, wherein the first conductivity type and the second conductivity type are the same and the first doping concentration exceeds the second doping concentration by at least a factor of 10.

8. The power semiconductor device (1) according to claim 6, wherein the first conductivity type and the second conductivity type are different, and each pillar-shaped or fin-shaped region (20) comprises a drain layer (23) of the first conductivity type arranged on a side of the channel layer (22) facing away from the contact layer (21).

9. The power semiconductor device (1) according to claim 5, wherein the channel layers (22) are arranged in a plane different from a plane of the gate electrode layer (5), and the first insulating layer (6) comprises second insulating layer portions (6B) arranged on a side of the gate electrode layer (5) facing the second main electrode (4).

10. The power semiconductor device (1) according to the preceding claim, wherein the first conductivity type and the second conductivity type are different, and a drain layer (23) of the first conductivity type is arranged on sides of the channel layers (22) facing away from the contact layers (21).

11. The power semiconductor device (1) according to the preceding claims, wherein each pillar-shaped or fin-shaped region (20) has a first lateral extension (1) which is below 2 µm, or below 1 µm.

12. A method for manufacturing the power semiconductor device (1) according to any one of the preceding claims, the method comprising:
- providing a substrate (8),
- forming a sacrificial layer (11) on a first main side (8A) of the substrate (8),
- structuring the sacrificial layer (11) to form a plurality of sacrificial structures (12) protruding from the first main side (8A) and having the shape of a pillar or a fin,
- forming an insulating material layer (17) on at least one of the plurality of sacrificial structures (12) and the first main side (8A), wherein at least a part of the insulating material layer (17) forms the first insulating layer (6) in the power semiconductor device (1),
- removing at least one sacrificial structure (12) to form at least one cavity (16) in the insulating material layer (17),
- forming the gate electrode layer (5) on a second portion (17B) or second portions (17B) of the insulating material layer (17) which form(s) the at least one second insulating layer portion (6B) in the power semiconductor device (1),
- forming a semiconductor layer (15, 15A) of the first conductivity-type selectively on the first main side (8A) to form a contact layer (21) in the at least one cavity (16) extending to a side (5A) of the gate electrode layer (5) facing away from the substrate (8),
- forming the first main electrode (3) on a side of the semiconductor layer stack (2) facing away from the substrate (8),
- forming the second main electrode (4) on a side of the semiconductor layer stack (2) facing away from the first main electrode (3).

13. The method according to the preceding claim, wherein the method comprises forming the semiconductor layer (15, 15A) of the first conductivity-type which is provided to form the contact layers (21) after producing the gate electrode layer (5).

14. The method according to the two preceding claims, wherein the method comprises selectively forming a semiconductor layer (14) of the second conductivity-type on the first main side (8A) in each cavity (16) between the contact layers (21) and the substrate (8) to form the channel layers (22).

15. The method according to the preceding claim, wherein the method comprises selectively forming a semiconductor layer (13) of the first conductivity-type on the first main side (8A) in each cavity (16) between the channel layers (22) and the substrate (8) to form the drain layers (23).
